Europäisches Patentamt

**(19)** European Patent Office

Office européen des brevets

**(11)** Publication number: **0 043 191**

**A1**

# **(12)** EUROPEAN PATENT APPLICATION

**(21)** Application number: **81302508.7**

**(22)** Date of filing: **05.06.81**

**(51)** Int. Cl.³: **G 01 R 33/06**

**(30)** Priority: **25.06.80 GB 8020760**

**(43)** Date of publication of application:
**06.01.82 Bulletin 82/1**

**(84)** Designated Contracting States:
**CH DE FR LI NL SE**

**(71)** Applicant: **The General Electric Company Limited**
**1 Stanhope Gate**
**London W1A 1EH(GB)**

**(72)** Inventor: **Antoszewski, Eugeniusz**
**58 Victoria Way**
**Stafford(GB)**

**(74)** Representative: **Pope, Michael Betram Wingate**
**The General Electric Company Limited Central Patent**
**Department Hirst Research Centre East Lane**
**Wembley Middlesex HA9 7PP(GB)**

**(54) Carrier-domain magnetometers.**

**(57)** A carrier-domain magnetometer incorporating a temperature sensitive power source (VR, I1, I2, V) so that the electrical bias applied to the semiconductor structure (3, 2, 4, 5) of the magnetometer varies with temperature so as to reduce the variation with temperature of the frequency of domain rotation.

FIG.4.

EP 0 043 191 A1

This invention relates to carrier-domain magnetometers.

A carrier-domain magnetometer comprises a semiconductor device incorporating a p-n-p-n structure of circular geometry, a power source for applying a reverse bias voltage across the central p-n junction of said structure and feeding respective currents to the end p-region and the end n-region of said structure so that current flow in the device occurs in a limited domain which subtends a small angle at the central axis of said structure; and means for deriving from the device a signal which will have different magnitudes for different angular positions of the domain with respect to the central axis. The principles of operation of such magnetometers, and details of one type of semiconductor device suitable for use therein, are described in two articles appearing at pages 608-611 of Volume 12 of "Electronics Letters"; further details of these matters are given in a paper appearing at pages 176-184 of Volume 2 of "Solid-state and Electron Devices". Another type of semiconductor device suitable for use in carrier-domain magnetometers is disclosed in British Patent Specification No. 2,004,117.

If the p-n-p-n structure of a carrier-domain magnetometer is subjected to a sufficiently strong magnetic field directed substantially parallel to its central axis, the carrier domain will rotate continuously around the central axis at a rate dependent on the flux density parallel to that axis; this will give rise to a cyclic variation in the signal derived from the semiconductor device, the frequency of which gives a measure of flux density. Ideally rotation of the carrier domain would occur for any value of the flux density, but in practice it is found that there is a threshold value (dependent on the precise electrical bias conditions) below which rotation does not occur, because inescapable inhomogeneities in the device structure tend to cause the carrier domain to stick at a particular angular position. However, for flux densities considerably above the threshold, the domain rotation frequency is substantially directly proportional to flux density.

It is possible to use a carrier-domain magnetometer for the measurement of magnetic fields whose magnitudes are below the threshold value by applying a constant biassing field having a flux density above the threshold value, and to sense the change in the domain rotation frequency resulting from the superimposition of the field to be measured on the biassing field.

A problem that occurs in the operation of a carrier-domain magnetometer is that of sensitivity of the frequency/flux density characteristic to variations in the operating conditions (temperature and electrical bias conditions) of the semiconductor device. In respect of temperature variations, for example, it is found that in general with increasing temperature the threshold value of flux density increases, and the slope of the linear part of the characteristic decreases; in particular the slope may be reduced by about 30% for a $25^{o}C$ increase in temperature. Thus if accurate measurements of flux density are to be made with a carrier-domain magnetometer it is necessary either to control closely the temperature and electrical bias conditions of the semiconductor device or to provide some form of compensation in respect of variations in these factors. While sufficiently close control of the bias conditions can normally be achieved by means of conventional stabilisation techniques, a similarly close control of temperature would not be feasible in many applications of the magnetometer, for example those in which the semiconductor device must be exposed to normal ambient conditions.

It is an object of the present invention to provide a carrier-domain magnetometer incorporating an effective form of compensation in respect of variations in the operating temperature of the semiconductor device. The form of compensation incorporated in the invention has the further advantage that it takes the form of an electric circuit which can conveniently be integrated with the semiconductor device on a semiconductor chip.

According to the present invention in a carrier-domain magnetometer the power source is arranged to vary said reverse bias voltage with temperature so as to reduce the variation with temperature of the frequency of domain rotation in the presence of a magnetic field directed parallel to the central axis of said structure over a range of temperature variation, and to maintain the domain rotation frequency of the device substantially in the middle of its range of variation with said reverse bias voltage throughout said range of temperature variation.

Preferably, the power source is also arranged to vary the current fed to the end p-region and/or the end n-region of said structure so as further to reduce the variation of domain rotation frequency with temperature.

One carrier-domain magnetometer in accordance with the invention will now be described by way of example with reference to the accompanying drawings, in which:-

Figure 1 is a sectional view of part of a semiconductor body incorporated in the magnetometer;

Figure 2 is a plan view of that part of the semiconductor body;

Figure 3 is a block schematic diagram of the whole magnetometer;

Figure 4 is a circuit diagram of the magnetometer; and

Figures 5 to 9 are graphs illustrating the operation of the magnetometer.

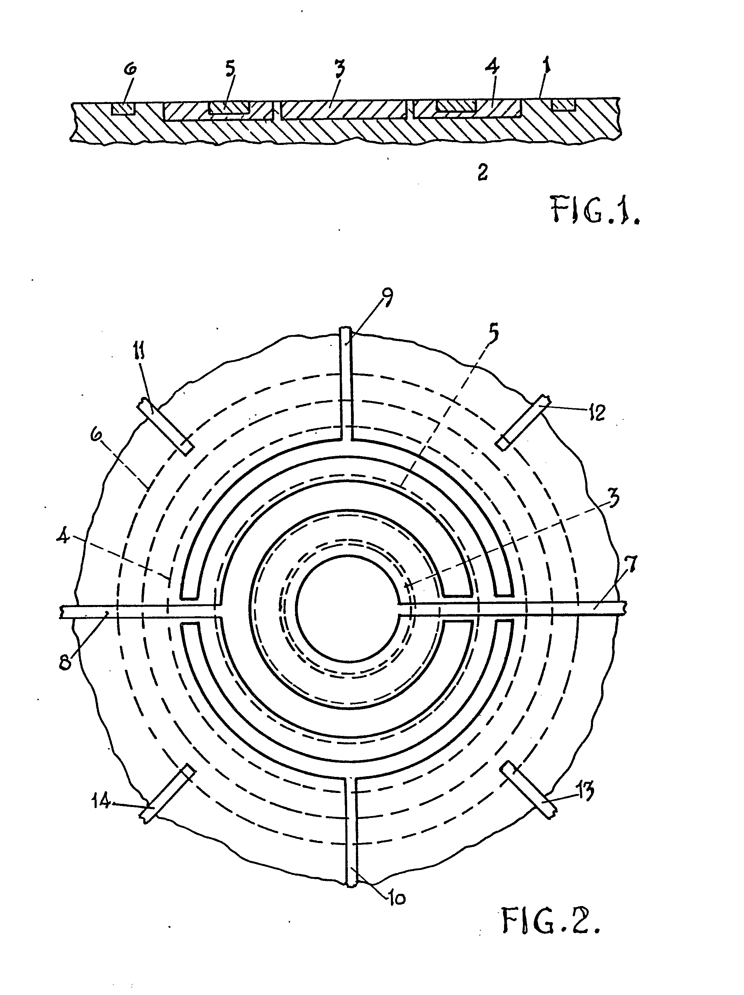

The magnetometer to be described utilises a semiconductor device of the type which is the subject of British Patent Specification No. 2,004,117, the device being illustrated in Figures 1 and 2. Referring to Figure 1, the device incorporates a semiconductor body in the form of a silicon chip having parallel planar main faces, only one of which (referenced 1) is shown in the drawing. The basic material 2 of the chip is n-type, of resistivity about two ohm-cm, and in the completed device this material serves to form the collector region of an n-p-n transistor structure and the base region of a p-n-p transistor structure. Various other regions 3, 4, 5 and 6 are formed in the chip by diffusion of appropriate impurities through the face 1, the regions 3 and 4 being p-type and the regions 5 and 6 being n-type of low resistivity; the region 3 is of substantially cylindrical form, while the regions 4, 5 and 6 are of annular forms coaxial with the region 3. In the completed device the regions 3 and 5 respectively serve as the emitter regions of the p-n-p and n-p-n transistor structures, the region 4 serves to form the collector region of the p-n-p structure and the base region of the n-p-n structure, and the region 6 serves to provide a low resistance non-rectifying contact to the region 2. Suitably the region 3 may have a diameter of about 120 microns, the radial gap between the regions 3 and 4 may have a width of about two microns, the overall radial width of the region 4 may be about 110 microns, the region 5 may have an inner diameter of about 170 microns and a radial width of about 40 microns, and the region 6 may have an internal diameter of about 400 microns and a radial width of about 30 microns. In Figure 1, the depths of the regions 3, 4, 5 and 6 are greatly exaggerated compared with their lateral dimensions; they may suitably have values of about three

microns for the regions 3 and 4 and two microns for the regions 5 and 6.

The diffusion processes for forming the regions 3, 4, 5 and 6 are carried out in two stages, the first using boron to form the region 3 and an annular p-type region corresponding in volume to the final regions 4 and 5 (suitably with a final sheet resistance of about 100 ohms per square) and the second using phosphorus to form the regions 5 and 6 (suitably with a final sheet resistance of about five ohms per square) and leave the remainder of the annular p-type region constituting the final region 4. In each stage the lateral extent of the diffusion is controlled in conventional manner by effecting the diffusion through apertures formed in an oxide layer (not shown) on the face, the oxide layer being reformed after each stage.

Referring now to Figure 2, the device also includes an electrode system in the form of a series of metallic conductors 7 to 14, which are formed by deposition on the chip after completion of the diffusion processes. The conductors 7 to 14 are deposited partly directly on the face 1, through suitable apertures formed in the oxide layer, and partly on the surface of this layer, the arrangement being such that each conductor is in direct contact with one, and only one, of the regions 3, 4, 5 and 6, the positions of which are indicated by the broken lines in Figure 2. Thus the conductor 7 is in contact with the region 3 over a central circular area, the conductor 8 is in contact with the region 5 over an area which is nearly a complete annulus but has a gap to accommodate the conductor 7, the conductors 9 and 10 are in contact with the region 4 over diametrically opposed areas, disposed outwardly of the region 5, which between them form nearly a complete annulus but leave gaps to accommodate the conductors 7 and 8, while the conductors 11 to 14 are in contact with the region 6 over small areas respectively disposed at angular intervals of 90° around the region 6. The conductors 7 to 14 extend outwardly to conventional bonding pads (not shown) by means of which external connections can readily be made to the device.

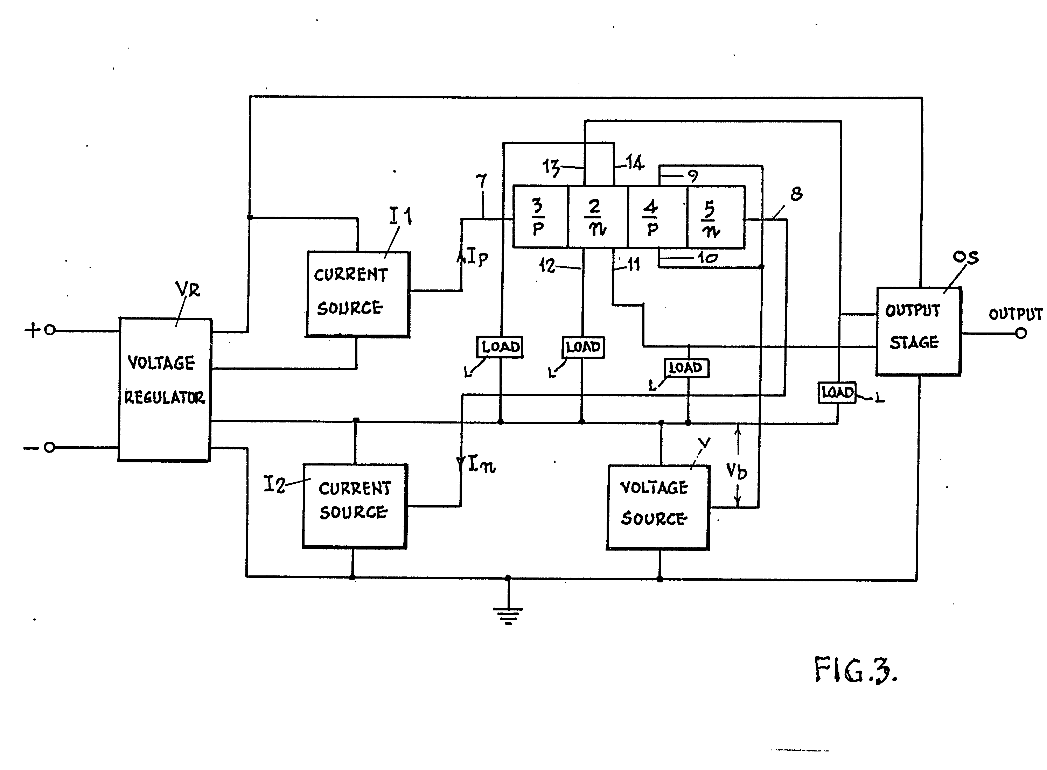

It will be appreciated that the device illustrated in Figures 1 and 2 includes a p-n-p-n structure of circular geometry constituted by the regions 3, 2, 4 and 5. In operation this structure is electrically biassed so as to form a carrier domain in it. Referring now also to Figure 3, this involves the application of a reverse bias voltage Vb from a voltage source V to the p-n junction between the regions 2 and 4 (which serves as the collector-base junction for both transistor structures), and the feeding of currents Ip and In to the regions 3 and 5 from sources I1 and I2 in such senses as to cause holes to be injected from the region 3 (p-n-p transistor emitter) into the region 2 and electrons to be injected from the region 5 (n-p-n transistor emitter) into the region 4. The various sources V, I1 and I2 are energised from a d.c. supply by way of a voltage regulator VR. By virtue of the regenerative coupling between the two transistor structures, the actual minority carrier injection is concentrated in a domain of limited angular extent, which will be caused to rotate around the central axis of the structure if the device is subjected to a sufficiently strong magnetic field directed substantially parallel to this axis. The rotation of the carrier domain will give rise to cyclic variations in the individual currents flowing through the conductors 11 to 14, so that the rotation can be sensed by an output stage OS supplied with one or more (two in Figure 3) of the signals developed across loads L connected with the conductors 11 to 14, these signals being in the form of trains of current pulses whose recurrence frequency is equal to the domain rotation frequency.

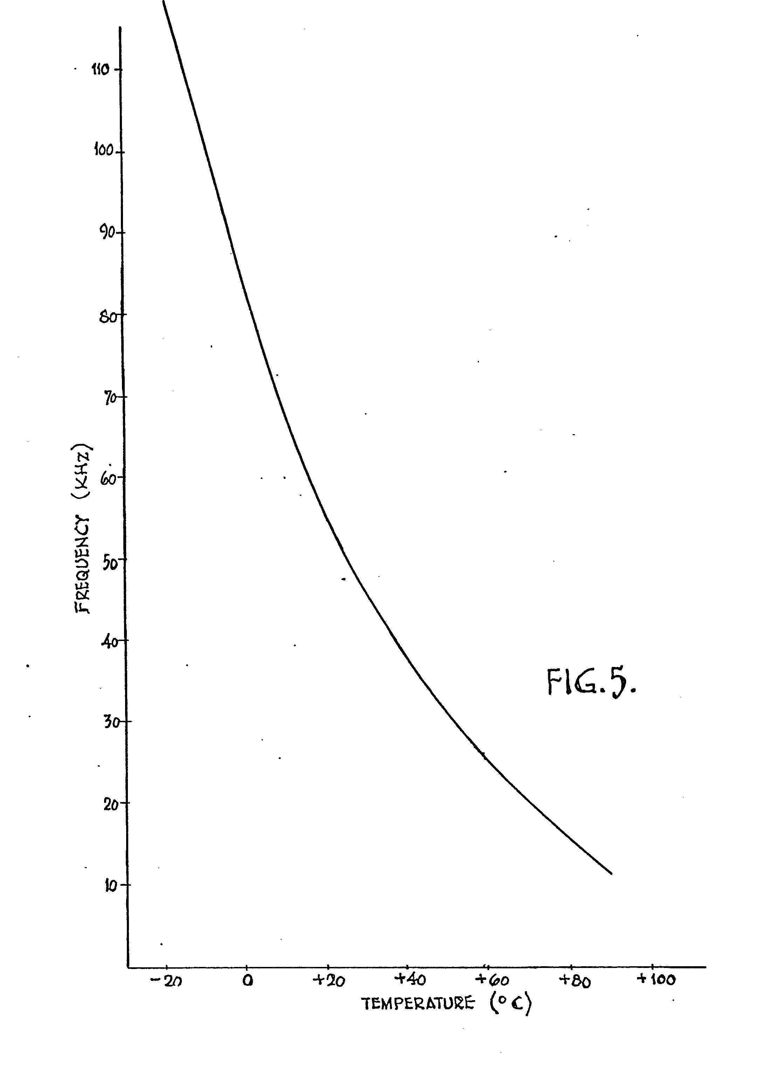

With the sources V, I1 and I2 providing constant biasses and a steady applied magnetic field, the domain rotation frequency of a typical p-n-p-n structure varies with the temperature of the p-n-p-n structure as shown in Figure 5.

In accordance with the invention, compensation for this is provided by arranging for the biasses supplied by the sources V, I1 and I2 to vary with temperature.

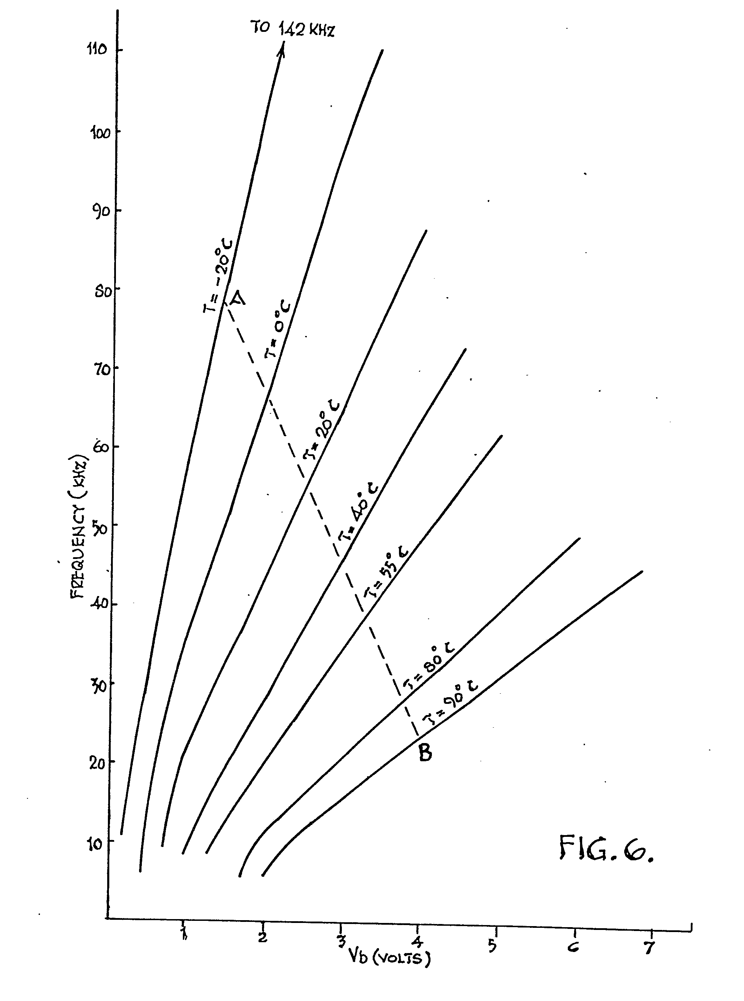

An indication of the way in which compensation can be effected with a typical p-n-p-n structure by control of the bias voltage Vb can be seen from Figure 6 which shows the variation of domain rotation frequency with the bias voltage Vb at various temperatures. It will be seen from Figure 6 that domain rotation frequency is proportional to bias voltage Vb over an appreciable range, and that by increasing bias voltage Vb along line AB with increase of temperature and vice versa the variation domain rotation frequency is only from 78 kHz to 23 kHz over a temperature range $-20^{\circ}$C to $90^{\circ}$C compared with a variation of from 12 kHz to over 110 kHz with constant biasses, as shown in Figure 5.

Furthermore, the working point is maintained approximately in the middle of the dynamic range of Vb which is important when it is desired to control domain rotation frequency by variation of the voltage across the p-n junction between regions 2 and 4 as well, or instead of, applied magnetic field.

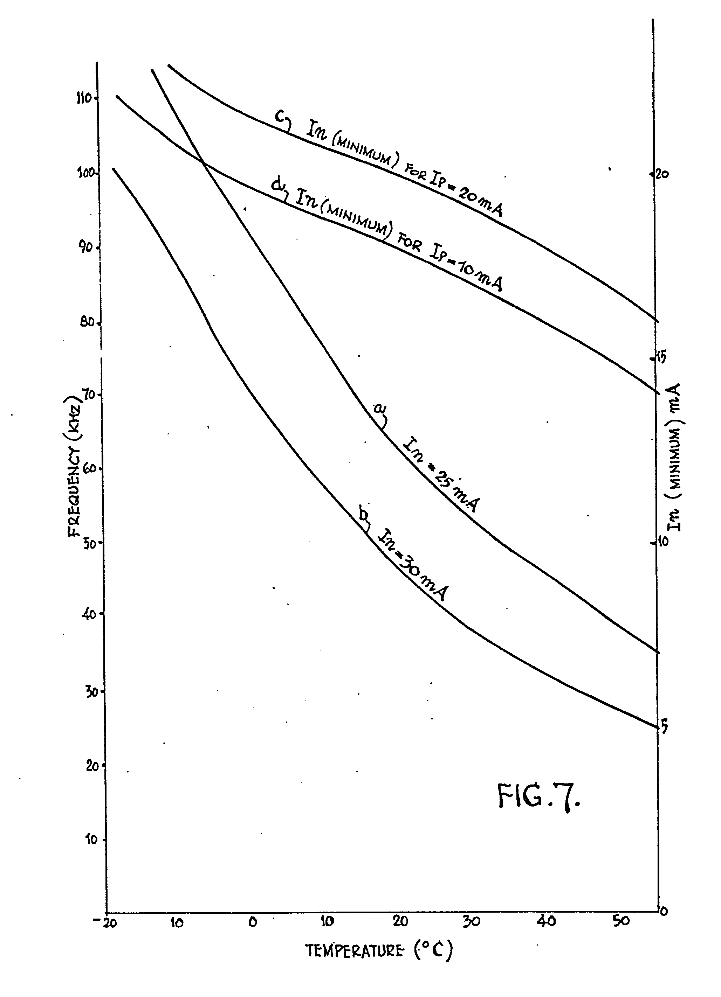

An indication of the way in which compensation can be obtained by control of the output of current source I1 can be seen from Figure 7 in which lines a and b show the variation in domain rotation frequency with temperature for two different values of In. As can be seen, domain rotation frequency varies inversely with In so that temperature compensation can be effected by decreasing In with temperature.

In practice the possible range of variation of In is limited, the upper limit of In being determined by thermal dissipation in the p-n-p-n structure and the lower limit by the minimum value of In at which a carrier domain will form in the p-n-p-n structure, this lower limit depending in turn on the value of Ip. In Figure 7 lines $\underline{c}$ and $\underline{d}$ show the variation of the minimum possible value of In with temperature for two different values of Ip. For a typical p-n-p-n structure a maximum permissible value of Ip of 20 milliamps may be chosen and the bias current In made 20 milliamps at $20^{o}$C and varied through $\pm$ 2 milliamps over the temperature range $-20^{o}$C to $70^{o}$C.

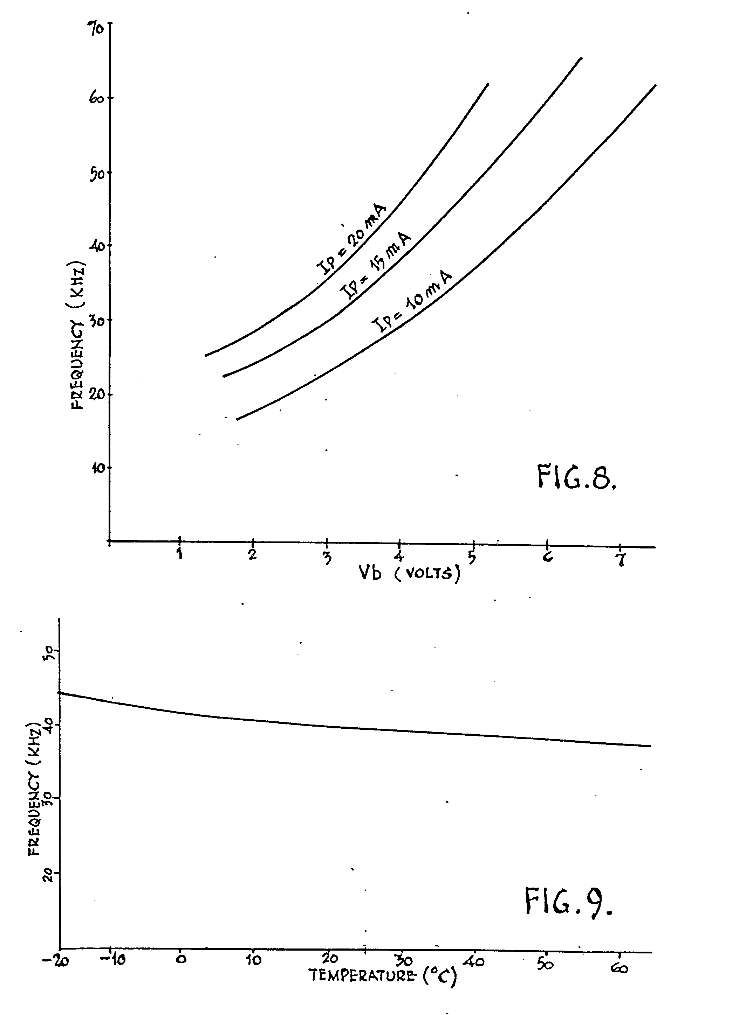

The variation of domain rotation frequency with bias current Ip is shown in Figure 8 from which it can be seen that domain rotation frequency is approximately proportional to current Ip so that temperature compensation can be effected by increasing current Ip with temperature.

The upper limit for Ip is chosen in conjunction with In, as described above, and the lower limit in dependence on the value of voltage bias Vb applied at minimum temperature. In a typical arrangement Ip is arranged to vary over the range 10 to 20 milliamps.

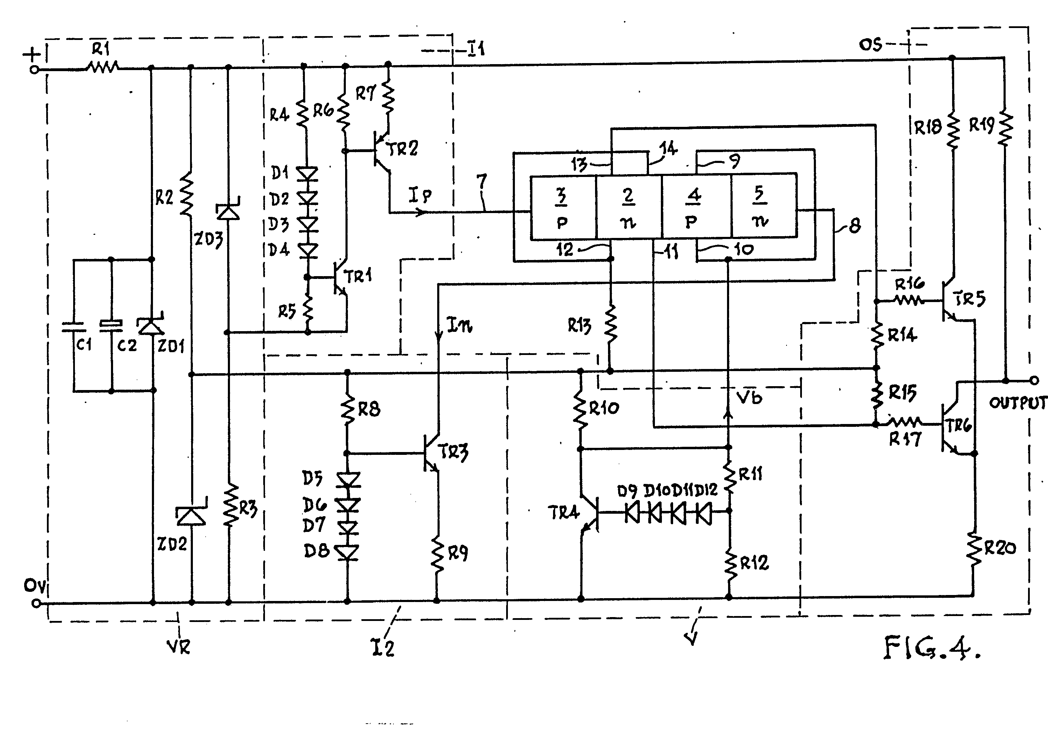

Referring now to Figure 4, in one particular embodiment of the magnetometer of Figure 3 the voltage regulator VR is of conventional form and comprises resistors R1 to R3, capacitors C1 and C2 and zener diodes 2D1 to 1D3 to produce three constant voltage outputs across diodes ZD1, ZD2 and ZD3 respectively.

The current source I1 comprises a transistor TR1 which is connected in a constant current source configuration and drives a transistor TR2 whose collector current constitutes the current Ip. The required variation of Ip with temperature is obtained due to the temperature sensitivity of the base-emitter junctions of transistors TR1 and TR2 and diodes D1 to D4 connected in the emitter-base junction biassing arrangement of transistor TR1. With rise in temperature the collector current of transistor TR1 increases which drives transistor TR2 to heavier conduction and increases bias current Ip.

The current source I2 comprises a transistor TR3 connected in a constant current configuration whose collector current constitutes the current In. The required variation of In with temperature is obtained due to the temperature sensitivity of diodes D5 to D8 connected in the emitter-base biassing arrangement of transistor TR3. With rise in temperature increased current flows through diodes D5 to D8 with corresponding reduction in the base current of transistor TR3, and hence a reduction in bias current In.

The voltage Vb is derived from the collector of a transistor TR4 connected in a negative feedback arrangement to stabilize the voltage across collector load resistor R10.

The required variation of Vb with temperature is obtained due to the temperature sensitivity of the base-emitter junction of transistor TR4 and diodes D9 to D12 connected in series between the base of transistor TR4 and the junction of two resistors R11 and R12 which are connected in series between the collector and emitter of transistor TR4.

With rise in temperature the collector current of transistor TR4 increases with a corresponding increase in Vb.

The output stage OS comprises two transistors TR5 and TR6 provided with respective collector loads R18 and R19 and sharing a common emitter resistor R20, the output being derived from the collector of one of the transistors (TR6). The bases of the transistors TR5 and TR6 are connected via respective resistors R16 and R17 to oppositely positioned ones 11 and 13 of the four conductors 11 to 14, the other two conductors 12 and 14 being connected to a reference potential via a common load resistor R13, and the conductors 11 and 13 to the same reference potential via respective load resistors R15 and R14.

Figure 9 shows the variation of domain rotation

frequency with temperature of the magnetometer shown in Figure 4 under typical operating conditions.

The degree of temperature compensation effected by each of the sources V, I1 and I2 can conveniently be altered by altering the number of temperature sensitive diodes incorporated in that source.

It will be appreciated that the sources V, I1 and I2 are suitably fabricated in integrated circuit form on the same silicon chip as the p-n-p-n structure. The diodes D1 to D12 and transistors TR1 to TR4 will then all be accurately at the same temperature as the p-n-p-n structure providing fast temperature compensation with temperature change.

Due to its relatively high heat dissipation the voltage regulator VR is preferably mounted away from the silicon chip, but the output stage OS may conveniently be fabricated thereon.

CLAIMS

1.     A carrier-domain magnetometer comprising:  a semiconductor device incorporating a p-n-p-n structure (2, 3, 4, 5) of circular geometry; a power source (VR, V, I1, I2) for applying a reverse bias voltage (Vb) across the central p-n junction of said structure and feeding respective currents (Ip, In) to the end p-region (3) and the end n-region (5) of said structure so that current flow in the device occurs in a limited domain which subtends a small angle at the central axis of said structure; and means (9, 11, OS) for deriving from the device a signal which will have different magnitudes for different angular positions of the domain with respect to the central axis; characterised in that the power source is arranged to vary said reverse bias voltage with temperature so as to reduce the variation with temperature of the frequency of domain rotation in the presence of a magnetic field directed parallel to the central axis of said structure over a range of temperature variation, and to maintain the domain rotation frequency of the device substantially in the middle of its range of variation with said reverse bias voltage throughout said range of temperature variation.

2.     A magnetometer according to Claim 1 wherein said reverse bias voltage (Vb) is derived from a constant voltage source (V) arrangement including at least one temperature sensitive component (TR4, D9 to D12) incorporated in a biassing circuit of the arrangement and arranged to be at substantially the same temperature as said structure in operation.

3.     A magnetometer according to Claim 1 or Claim 2 wherein the power source is also arranged to vary the current (Ip) fed to the end p-region of said structure with temperature so as further to reduce the variation of domain rotation frequency with temperature.

4.      A magnetometer according to Claim 3 wherein said current fed to the end p-region of said structure is derived from a constant current source (I1) arrangement including at least one temperature sensitive component (TR1, TR2, D1 to D4) incorporated in a biassing circuit of the arrangement and arranged to be at substantially the same temperature as said structure in operation.

5.      A magnetometer according to any one of the preceding claims wherein the power source is also arranged to vary the current (In) fed to the end n-region of said structure with temperature so as further to reduce the variation of domain rotation frequency with temperature.

6.      A magnetometer according to Claim 5 wherein said current fed to the end n-region of said structure is derived from a constant current source arrangement (I2) including at least one temperature sensitive component (D5 to D8) incorporated in a biassing circuit of the arrangement and arranged to be at substantially the same temperature as said structure in operation.

7.      A magnetometer according to any preceding claim wherein said power source is fabricated at least partly in semiconductor integrated circuit form on the same chip as said p-n-p-n structure.

FIG.1.

FIG.2.

FIG.3.

FIG.4.

OUTPUT

FIG.5.

4/7

0043191

FIG.6.

FIG.7.

FIG.8.

FIG.9.

| European Patent Office | **EUROPEAN SEARCH REPORT** | Application number EP 81 30 2508 |
|---|---|---|

## DOCUMENTS CONSIDERED TO BE RELEVANT

| Category | Citation of document with indication, where appropriate, of relevant passages | Relevant to claim |
|---|---|---|
| | <u>FR - A - 1 391 853</u> (VARIAN ASSOCIATES) <br> * Page 5, column 1, line 25 - column 2, line 4 * <br><br> -- | 1 |
| D | <u>GB - A - 2 004 117</u> (G. BLOODWORTH et al.) <br> * Page 3, lines 60-70; page 4, lines 8-18; figures 1,2 * <br><br> ---- | 1,3,5 |

**CLASSIFICATION OF THE APPLICATION (Int Cl.3)**

G 01 R 33/06

**TECHNICAL FIELDS SEARCHED (Int. Cl.3)**

G 01 R 33/06

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member o the same patent family, corresponding document

The present search report has been drawn up for all claims

| Place of search | Date of completion of the search | Examiner |
|---|---|---|
| The Hague | 09-10-1981 | GALLO |

EPO Form 1503 1   06.78